# EUROPEAN PATENT APPLICATION

(11) **EP 1 583 140 A1**
(43) Date of publication of application: **05.10.2005**
(21) Application number: 04745738.7
(22) Date of filing: 10.06.2004
(51) Int. Cl.: H01L 21/304, B23K 26/40

(54) **METHOD FOR PRODUCING SEMICONDUCTOR SINGLE CRYSTAL WAFER AND LASER PROCESSING DEVICE USED THEREFOR**

(30) Priority: 20.06.2003 JP 2003176746
(71) Applicant: Sumitomo Electric Industries, Ltd., Osaka 541-0041 (JP)
(72) Inventor: OTSUKI, Makoto, Itami-shi, hyogo 6648611 (JP); NISHIKAWA, Masayuki, Itami-shi, hyogo 6648611 (JP); MATSUI, Yasuyuki, Itami-shi, hyogo 6648611 (JP)
(74) Representative: Grünecker, Kinkeldey, Stockmair & Schwanhäusser Anwaltssozietät
(86) International application number: PCT/JP2004/008108
(87) International publication number: WO 2004/114387

(57) **Abstract**

A method of manufacturing single-crystal semiconductor wafers is **characterized in that** a plurality of single-crystal semiconductor wafers of a relatively small diameter (2a-2d) desired by users are cut out from a single-crystal semiconductor wafer of a relatively large diameter (1a-1d). Therefore, there can also be obtained a secondary effect that even if the large-scale single-crystal semiconductor wafer has defective parts, the small-scale wafers cut out from the non-defective parts can be shipped to the market.

## Description

### Technical Field

The present invention relates to a method of manufacturing single-crystal semiconductor wafers, and in particular, to a method of efficiently producing single-crystal semiconductor wafers of a relatively small diameter at low costs, and a laser machining apparatus therefor.

### Background Art

At present, various types of semiconductor devices are manufactured from single-crystal semiconductor wafers. To improve the production efficiency of the semiconductor devices, there is generally a demand to use single-crystal semiconductor wafers of a diameter as large as possible to manufacture the semiconductor devices. Due to such a demand, in the case of silicon, there is grown a cylindrical single-crystal ingot having a large diameter of 12 inches (approximately 30.5 cm), for example, which is then cut by means of a slicer, a multi-wire saw or the like to thereby manufacture single-crystal wafers each having a 12-inch diameter.

In the case of a compound semiconductor such as a III-V group compound or a II-VI group compound, growing a large-scale, single-crystal ingot is much more difficult than in the case of silicon. Conventionally, therefore, single-crystal ingots of the compound semiconductor having a 2-inch (approximately 5.1-cm) diameter have mainly been grown, which are cut to provide single-crystal wafers having a 2-inch diameter to be used for manufacturing semiconductor devices.

### Disclosure of the Invention

### Problems to be Solved by the Invention

In recent years, improvements have been carried out in the technique of growing single-crystal compound semiconductor ingots. In some types of compound semiconductors, it is possible to grow a single-crystal ingot having a relatively large diameter of 5 inches (approximately 12.7 cm) or 6 inches (approximately 15.2 cm), for example.

As described above, however, industrially available single-crystal compound semiconductor wafers conventionally have a 2-inch diameter. Therefore, production lines on which single-crystal compound semiconductor wafers are used to manufacture semiconductor devices have conventionally been constructed suitably for the 2-inch wafers. At present, there still exist a large number of such production lines and they are still in operation. Therefore, even if it is possible to grow single-crystal compound semiconductor ingots having a relatively large diameter of 5 inches or 6 inches, for example, the existing production lines still have a demand for single-crystal compound semiconductor wafers having a 2-inch diameter.

Incidentally, a wafer referred to as having a 2-inch diameter does not necessarily mean that it exactly has a 2-inch diameter, and tolerance of approximately 5% is allowable. Accordingly, the production lines are also constructed to be able to allow for variations in wafer diameter of approximately 5%. Such tolerance of the wafer diameter is also applicable to wafers having a standard diameter other than the 2-inch diameter.

Under the circumstances described above, even if a semiconductor wafer provider has a technique of growing single-crystal compound semiconductor ingots having a 5-inch or 6-inch diameter, for example, the provider specially grows single-crystal ingots having a 2-inch diameter to meet the demand for 2-inch diameter wafers. Then, the provider grinds the outer periphery of the ingot, and the grinding includes a process of forming an orientation flat (OF) and, if desired, an index flat (IF) too for indicating a crystal orientation. A notch may be formed instead of the OF and IF. Furthermore, the provider slices the ingot and polishes the obtained slices to produce target 2-inch diameter wafers.

As a matter of course, in order to obtain a total wafer area equal to that provided by large-scale wafers of a 5-inch or 6-inch diameter by using small-scale wafers of a 2-inch diameter, several times number of the small-scale wafers are required as compared with the number of the large-scale wafers. To provide such many small-scale wafers, it is necessary to grow many small-scale ingots and cut the same into many wafers as well.

This means that a large number of crystal growth furnaces and wafer cutting devices are required, which is undesirable in terms of costs and efficiency of wafer production. In such a situation, it may be possible to grow a plurality of small-scale single-crystal ingots in a large furnace in which a large-scale single-crystal ingot can be grown. In such a large furnace, however, it is difficult to uniformly adjust growth conditions of a plurality of small-scale single-crystal ingots, and thus it is difficult to obtain at one time a plurality of small-scale single-crystal ingots having a uniform and preferable crystal quality. It may also be possible to simultaneously cut a plurality of small-scale ingots by binding them together so as to simplify the cutting process. However, such a cutting process becomes unstable, which makes it difficult to obtain target wafers having an accurate crystal orientation.

In view of such circumstances of the conventional art, an object of the present invention is to provide a method of efficiently manufacturing single-crystal semiconductor wafers of a relatively small diameter at low costs, and a laser machining apparatus therefor.

### Means for Solving the Problems

A method of manufacturing single-crystal semiconductor wafers according to the present invention is characterized in that a plurality of single-crystal semiconductor wafers having a relatively small diameter desired by users are cut out from a single-crystal semiconductor wafer having a relatively large diameter. Such a method is particularly preferable in the case that the semiconductor is a compound semiconductor such as GaAs, InP or GaN.

The large-scale wafer to be cut preferably has a thickness in a range of 0.15 mm to 1.5 mm The wafers can be cut out by any of a laser method, an electric discharge machining method, a water jet method, a wire saw method, an ultrasonic method, and a grinding method by means of a cylindrical core on which diamond is electrically deposited. In particular, the laser method, electric discharge machining method, water jet method, and wire saw method, which enable easy cutting along both straight and curved lines in a fully-controlled manner, are preferable because these methods can be used to form OFs and IFs easily by setting an XY-driving stage control device.

In the cutting process, at least three small-scale wafers having a diameter of at least 2 inches can be cut out from one large-scale wafer having a diameter of at least 4 inches, and at least four small-scale wafers having a diameter of at least 2 inches can be cut out from one large-scale wafer having a diameter of at least 5 inches, and at least seven small-scale wafers having a diameter of at least 2 inches can be cut out from one large-scale wafer having a diameter of at least 6 inches. For efficient use of wafers, a total area of small-scale wafers cut out from a single large-scale wafer preferably corresponds to at least 50% of an area of the large-scale wafer. On the other hand, when defective parts included in a large-scale wafer (twin-crystals, polycrystals, crystal slips, chips, cracks or the like) correspond to at most 65% of an area of the large-scale wafer, small-scale wafers can be cut out from the remaining part of the large-scale wafer. Furthermore, in terms of processing efficiency, small-scale wafers are preferably cut out from a plurality of large-scale wafers in a stacked state.

Each of the small-scale wafers is preferably provided with a mark for indicating that each of them is cut out from what part of the large-scale wafer. Each of the small-scale wafers may be processed to have an orientation flat and an index flat. In such a case, each of the small-scale single-crystal semiconductor wafers is preferably cut out to have a protruding margin to be gripped when cleavage is carried out to form an orientation flat. Furthermore, each of the small-scale wafers can have, preferably on the protruding margin, the mark for indicating that each of them is cut out from what part of the large-scale wafer. On the other hand, each of the small-scale wafers may have a notch for enabling easy determination of its crystal orientation and alignment.

The small-scale wafers are preferably cut out by using a YAG laser beam, in particular, a YAG pulse laser. In such a case, the small-scale wafers are preferably cut out such that a plurality of holes in the large-scale wafer each made by a single shot of the pulse laser are aligned successively with the neighboring holes overlapping each other in a range of 30% to 87% of their diameters. The large-scale wafer preferably has a main surface as sliced from an ingot, a main surface subsequently washed, or a main surface after a surface layer have been etched away by a thickness of at most 10 µm. Such a main surface is preferably irradiated with the laser beam.

The large-scale wafer before cutting is preferably supported by a plurality of supporting devices for supporting the plurality of small-scale wafers to be obtained after cutting. The supporting device has a supporting area smaller than the small-scale wafer. The supporting device may be a vacuum chuck. The supporting device may also be a pinholder, and a weight may be placed on the wafer and arranged above the pinholder or a magnet may be placed on the wafer and arranged above the pinholder having a magnetic property, so as to support the wafer more stably.

A gas is preferably jetted to blow off residues caused during cutting with the laser beam. The gas and the residues are preferably sucked and introduced into a dust collector. The laser beam is preferably adjusted such that an opening made by cutting with the laser beam has a width larger on a main surface side of the wafer to which the laser beam is incident than on the other main surface side of the wafer, and a side surface of the opening is preferably made at an angle ranging from 65 to 85 degrees with respect to the main surface of the wafer.

Each of the small-scale wafers preferably has a mark for indicating that each of them is cut out from what part of each of the large-scale wafers sliced from the same ingot, and the small-scale wafers cut out from the corresponding parts of the large-scale wafers are preferably grouped into the same lot.

Residues which have been caused during cutting and have adhered to a periphery of the small-scale wafer are preferably removed by rubbing. A peripheral side layer of the small-scale wafer is preferably removed with a grinder of rubber by a thickness of at most 0.3 mm Alternatively, the peripheral side layer may be removed by at most 0.1 mm and then either edge or both edges of the peripheral side are preferably beveled by a grinder of rubber. It is also preferable to etch the entire small-scale wafer to remove contaminations after the periphery of the wafer is processed by a grinder of rubber.

A laser machining apparatus for cutting out a plurality of single-crystal semiconductor wafers of a relatively small diameter from a single-crystal semiconductor wafer of a relatively large diameter by a laser beam can be constructed including: a plurality of supporting devices for supporting from underneath a plurality of regions to be cut out from the large-scale wafer to provide the plurality of small-scale wafers; a laser device including a laser beam window supported by an XY stage above the large-scale wafer; and a gas ejector for jetting a gas to blow off residues caused during cutting with the laser beam.

The supporting device may include a vacuum chuck or a pinholder, and has a supporting area which is set smaller than a main surface of the small-scale wafer. If the supporting device includes a pinholder, it preferably further includes a weight to be placed on the wafer and arranged above the pinholder, or a magnet to be placed on the wafer and arranged above the pinholder having a magnetic property.

Along with the laser device, the gas ejector is preferably supported by the XY stage. It is also preferable to further provide a dust collector for sucking the gas and the residues below the wafer to remove the residues.

For the laser device, a YAG laser device, particularly a YAG pulse laser device may preferably be used. The laser beam window is preferably connected to a laser generating source via an optical fiber.

### Effects of the Invention

According to the present invention, there can be provided a method of efficiently manufacturing single-crystal semiconductor wafers of a relatively small diameter from a single-crystal semiconductor ingot of a relatively large diameter at low costs, and a laser machining apparatus therefor.

### Brief Description of the Drawings

Fig. 1 is a schematic plan view showing how a single-crystal semiconductor wafer of a 4-inch diameter is cut to provide three single-crystal semiconductor wafers of a 2-inch diameter in an embodiment according to the present invention.
Fig. 2 is a schematic cross-sectional block diagram showing an example of a laser machining apparatus according to the present invention.
Fig. 3 is a schematic cross section showing an opening made by cutting of a wafer.
Fig. 4 is a schematic plan view showing how a single-crystal semiconductor wafer of a 5-inch diameter is cut to provide four single-crystal semiconductor wafers of a 2-inch diameter in another embodiment according to the present invention.
Fig. 5 is a schematic plan view showing how a single-crystal semiconductor wafer of a 6-inch diameter is cut to provide seven single-crystal semiconductor wafers of a 2-inch diameter in a further embodiment according to the present invention.
Fig. 6 is a schematic plan view showing how a single-crystal semiconductor wafer of a 6-inch diameter is cut to provide seven single-crystal semiconductor wafers of a 2-inch diameter and having a protruding margin to be gripped when cleavage is carried out.

### Description of the Reference Characters

1a: single-crystal wafer of a 4-inch diameter, 1b: single-crystal wafer of a 5-inch diameter, 1c and 1d: single-crystal wafer of a 6-inch diameter, 2a, 2b, 2c and 2d: single-crystal wafer of a 2-inch diameter, 2d1: margin to be gripped when cleavage is carried out, 2d2: mark, 3: opening made by cutting, 11: funnel-shaped metallic container, 12: vacuum chuck, 13: laser beam window, 13a: laser beam, 14: optical fiber, 15: laser generator, 16: gas ejector: 16a: jet of gas, 17: dust collector.

### Best Modes for Carrying Out the Invention

### First Embodiment

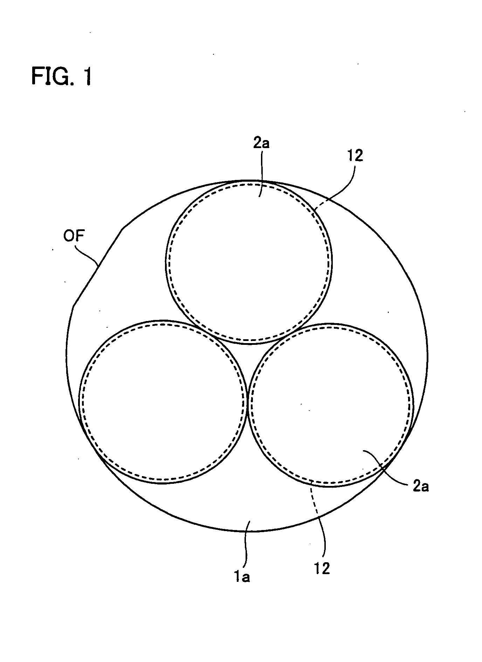

Fig. 1 is a schematic plan view showing a process of manufacturing single-crystal semiconductor wafers of a small diameter from a single-crystal semiconductor ingot of a relatively large diameter in a first embodiment according to the present invention. At present, for a GaAs compound semiconductor, for example, it is possible to grow a single-crystal ingot having a relatively large diameter of 5 inches or 6 inches. For an InP compound semiconductor, it is almost possible to grow a single-crystal ingot having a relatively large diameter of 4 inches or more.

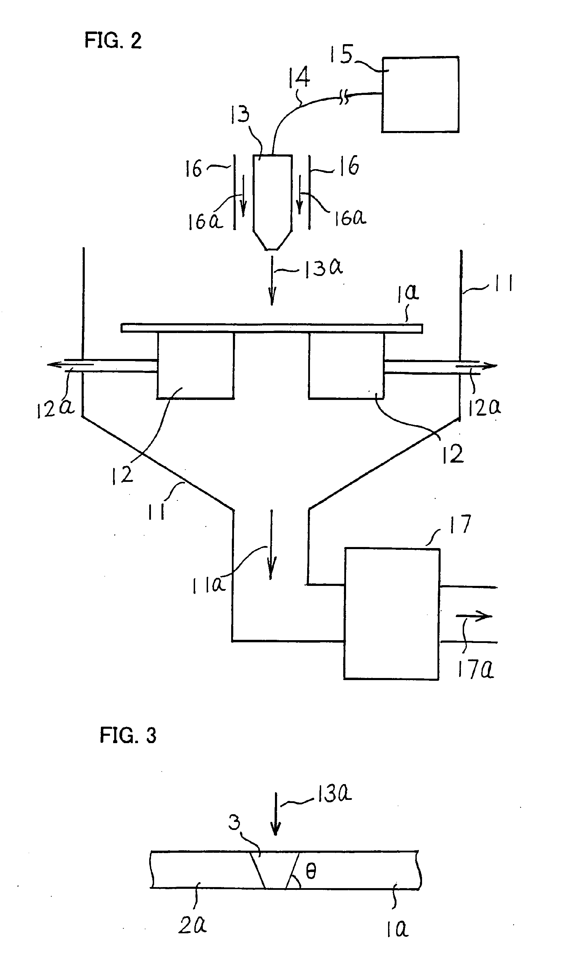

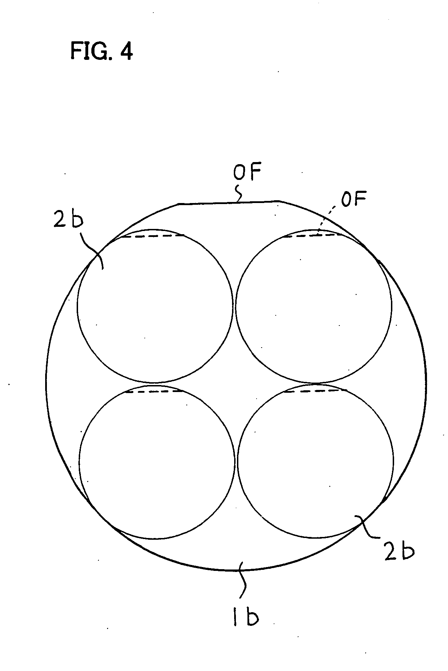

In the first embodiment, there is initially grown a single-crystal compound semiconductor ingot of a 4-inch diameter (actually, the diameter is slightly larger than 4 inches for including a grinding allowance), and then its outer periphery is ground and an OF is formed thereon. This 4-inch diameter ingot is cut by a slicer, a multi-saw or the like, to provide a 4-inch diameter wafer 1a. As shown in Fig. 1, 4-inch diameter wafer 1a is then cut by a laser, for example, to provide three 2-inch diameter wafers 2a. Such laser cutting can be carried out by using a laser machining apparatus as shown in a schematic cross-sectional block diagram of Fig. 2.

The laser machining apparatus of Fig. 2 includes a funnel-shaped metallic container 11. Provided in metallic container 11 are a plurality of vacuum chucks 12 which support 4-inch diameter wafer 1a. In the case that three 2-inch diameter wafers 2a are to be cut out from 4-inch diameter wafer 1a, three vacuum chucks 12 are provided corresponding to the three 2-inch diameter wafers. Vacuum chuck 12 has a supporting area smaller than 2-inch diameter wafer 2a. Air is evacuated from each of vacuum chucks 12 as shown by an arrow 12a, and 4-inch diameter wafer 1a is sucked and supported by vacuum chuck 12.

Since vacuum chuck 12 has a supporting area smaller than a small-scale wafer to be cut out, it is not damaged by a laser beam. With a view to preventing residues caused during cutting from adhering to a lower side of the small-scale wafer, however, vacuum chuck 12 preferably has a diameter not much smaller than that of the small-scale wafer. As shown in Fig. 1, for example, it is preferable that vacuum chuck 12 has a diameter of approximately 49.8 mm when small-scale wafer 2a having a diameter of 50.2 mm is to be cut out. The reason why it is preferable to provide vacuum chuck 12 having a diameter not much smaller than that of the small-scale wafer is that a very small peripheral region on the back side of the small-scale wafer, which is not covered with vacuum chuck 12, is subsequently removed by peripheral grinding or peripheral polishing so that residues caused during cutting do not remain on the lower side of the finished small-scale wafer.

A pinholder may be used to support a wafer instead of the vacuum chuck. Such a pinholder also preferably has a supporting area smaller than a small-scale wafer to be cut out. In order to support a wafer more stably, it is preferable to place a weight on a wafer and arranged on the pinholder, or to place a magnet on a wafer and arranged above the pinholder having a magnetic property.

Arranged above wafer 1a is a laser beam window 13 (including an optical system such as lenses) supported by an XY-driving stage (not shown). Laser beam window 13 is connected to a laser generator 15 via an optical fiber 14. Arranged adjacent to laser beam window 13 is a gas ejector 16. Gas ejector 16 may include a plurality of gas jet orifices arranged to surround laser beam window 13, or may include a single gas jet orifice coaxially surrounding laser beam window 13. Not only laser beam window 13 but also gas ejector 16 is supported by the XY-driving stage. Gas ejector 16 is of course connected to a high-pressure gas source (not shown) via a flexible conduit (not shown). For the high-pressure gas source, nitrogen gas pressurized to 4 kg/cm², or air pressurized to 5 kg/cm² and others may be used. A lower portion of funnel-shaped metallic container 11 is connected to a dust collector 17.

A laser beam 13a emitted through laser beam window 13 is focused on single-crystal semiconductor wafer 1a. The XY-driving stage is connected to a control device not shown and enables laser beam window 13 to be moved freely on an XY plane. The control device can store in advance a cutting pattern, according to which the XY-driving stage can move laser beam 13 a with respect to wafer 1a. As such, three 2-inch diameter wafers 2a can be cut out from 4-inch diameter wafer 1a as shown in Fig. 1.

When a wafer is cut by laser beam 13a, a gas jet is directed to a cutting region of the wafer by gas ejector 16 as shown with an arrow 16a. Gas jet 16a blows away residues caused during cutting the wafer, and can prevent the residues from adhering to and remaining on the periphery of the 2-inch diameter wafer just cut out. As shown with an arrow 11a, the residues and gas 16a in the lower portion of metallic container 11 are sucked into dust collector 17 which then captures the residues and exhausts only a cleaned gas as shown with an arrow 17a. In other words, dust in the residues and toxic elements such as As in a GaAs semiconductor can be prevented from being exhausted.

As described above, a single process of growing a 4-inch diameter ingot and a single process of slicing the ingot can provide three times as many 2-inch diameter wafers as in the case of growing a 2-inch diameter ingot. Furthermore, the function of laser cutting as described above may also be used to cut out a wafer having an OF/IF or a notch. Each of the small-scale wafers may be provided with an identification mark. There is a possibility that a large-scale compound semiconductor wafer has some variations in crystal quality and electrical characteristics depending on its localized area, and thus such an identification mark can be used to identify such a localized area of the large-scale wafer from which the small-scale wafer is cut out, and to identify each of the small-scale wafers from the others. Regarding a plurality of small-scale wafers cut out from a plurality of large-scale wafers sliced off from the same ingot, a plurality of small-scale wafers having the same identification mark are preferably grouped into the same lot so that the small-scale wafers having similar characteristics can be identified readily. Such an identification mark may be provided by a stamp such as a rubber stamp, by scribing with a scriber or a laser beam, or the like.

For laser generator 15, it is preferable to use a YAG laser device, and in particular, a YAG pulse laser device. Compared to the YAG laser, a carbon-dioxide gas laser device has more difficulty in focusing a beam sharply, and requires a larger cutting allowance. Furthermore, an excimer laser is more expensive than the YAG laser device. Even in the case of YAG laser, the pulse laser requires a cutting allowance slightly larger than that of a Q-switched laser. However, the YAG pulse laser is more preferable because it can provide a higher cutting rate.

Preferably, a small-scale wafer is cut out such that a plurality of holes in a large-scale wafer each made by a single shot of the pulse laser are aligned successively with the neighboring holes overlapping each other in a range of 30% to 87% of their diameters. If these holes do not overlap each other, the small-scale wafer obtained by cutting often has cracks on its periphery. If these holes overlap each other in a range of less than 30% of their diameters, the small-scale wafer has a less smooth periphery. In contrast, if the diameters of the holes overlap too much, the cutting rate becomes too low as a natural consequence. If each of the holes has a larger diameter on a main surface of the wafer to which a laser beam is incident and a smaller diameter on the other main surface, it is preferable that the two smaller diameters overlap each other in the range of their 30% to 87%.

As seen in Fig. 3 showing a schematic cross section of a wafer, it is preferable that laser beam 13a is adjusted such that an opening 3 made by cutting with laser beam 13a has a width larger on one side of the wafer to which the laser beam is incident than on the other side, and such that the side surface of opening 3 is formed at an angle θ in the range of 65-85 degrees with respect to the main surface of the wafer. In such a case, gas jet 16a efficiently blows away droplets of semiconductor melted with laser beam 13 a, allowing less residues caused during cutting to adhere to the periphery of small-scale wafer 2a which has been cut out. In this case, the inclination angle θ of the side surface of opening 3 with respect to the main surface of the wafer can be changed by adjusting the focal position and focal depth of laser beam 13a as well as the gas jet.

In an example of the YAG pulse laser device commercially available, its lasing output can be adjusted in a range of 20 W to 150 W, and its lasing frequency is in a range of 150-500 pulse/second. Such a YAG pulse laser device can be used to cut a GaAs wafer having a thickness of approximately 0.5 mm, for example, at a cutting rate of approximately 10-30 mm/second.

A large-scale wafer to be cut with a laser preferably has a main surface as sliced from an ingot, a main surface washed after the slicing, or a main surface formed by etching away a surface layer by a thickness of at most 10 µm. If the main surface is finished to a mirror plane, a laser beam is reflected thereby and then laser cutting becomes difficult. In the case that the large-scale wafer has a main surface as sliced from an ingot, although laser cutting can be carried out, there is a possibility that the diameter of the small-scale wafer obtained by the laser cutting varies at parts where contaminations have adhered to the main surface. Such contaminations can be removed by washing, or by etching for removing a surface layer by a thickness of at most 10 µm. With such etching by a thickness at most 10µm, the main surface of the wafer can not be finished to be a mirror plane making laser cutting difficult.

The 2-inch diameter wafer cut out can have its periphery polished by edge rounding, for example, and can be provided with an OF, an IF or a notch and then be polished to be finished. Initially, residues which were caused during cutting and adhered to the periphery of the small-scale wafer is preferably removed by rubbing. It is not easy to etch away such residues relatively large in size. If the residues are to be removed by rubbing, it is sufficient to remove a peripheral side layer of the small-scale wafer by a grinder of rubber by a grinding allowance of at most 0.3 mm This is because laser cutting can be carried out with a relatively high precision by using numerical control, and thus it is sufficient to remove the residues remaining in the vicinity of the outer periphery. Alternatively, the small-scale wafer's peripheral side layer may be removed by a grinding allowance of at most 0.1 mm, and either or both edges of the peripheral side may be beveled by a grinder of rubber. By doing so, the residues remaining in the vicinity of the outer periphery can also be removed sufficiently.

Furthermore, after the small-diameter wafer has its periphery processed by a grinder of rubber as mentioned above, the entire wafer is etched to remove contaminations so as to be finished. For example, a GaAs wafer can be finished by etching with an etchant mainly containing ammonia and hydrogen peroxide. An InP wafer can be finished by etching with an etchant mainly containing sulfuric acid and hydrogen peroxide.

It is preferable that the 2-inch diameter wafer has a prescribed thickness depending on a semiconductor device formed thereon. Therefore, a large-scale wafer from which small-scale wafers are to be cut out is required to have a thickness which allows the small-scale wafers to have a prescribed thickness. However, such a large-scale wafer may be sliced off to have a thickness larger than that desired for a small-scale wafer in order to reduce defects such as cracks or chips during the slicing, and then can have its surface ground to have a thickness desired for the small-scale wafer. On the other hand, if the large-scale wafer has an excessively large thickness of more than 2 mm, the laser cutting thereof becomes difficult, and there is no demand for such excessively thick small-scale wafers. In general, therefore, it is preferable that a large-scale wafer has a thickness in a range of 0.15 mm to 1.5 mm, taking account of easiness of handling and cutting the wafer as well.

### Second Embodiment

Fig. 4 is a schematic plan view showing a process of manufacturing single-crystal semiconductor wafers of a 2-inch diameter from a single-crystal semiconductor wafer of a 5-inch diameter in a second embodiment according to the present invention. This process of manufacturing can be carried out similarly as in the first embodiment described above.

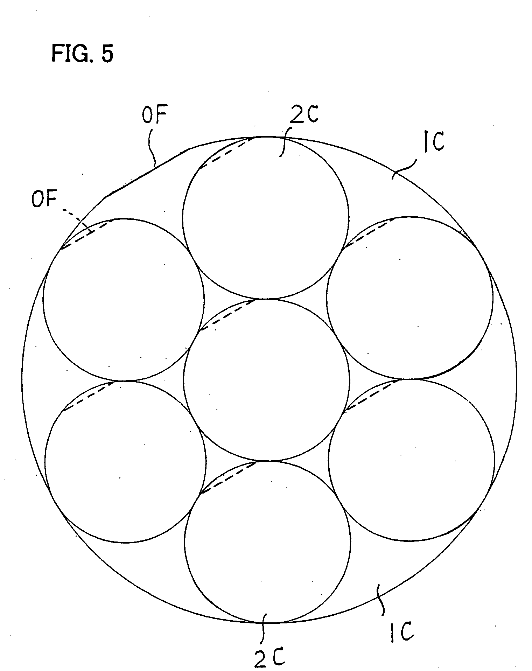

Namely, in the second embodiment, there is initially grown a single-crystal compound semiconductor ingot of a 5-inch diameter (actually, the diameter is slightly larger than 5 inches for including a grinding allowance), and then its outer periphery is ground and an OF is formed thereon. This 5-inch diameter ingot is cut by a slicer, a multi-saw or the like, to provide a 5-inch diameter wafer 1b. As shown in Fig. 4, 5-inch diameter wafer 1b can then be cut by a laser similarly as in the first embodiment to provide four 2-inch diameter wafers 2b.

In other words, a single process of growing a 5-inch diameter ingot and a single process of slicing the ingot can provide four times as many 2-inch diameter wafers as in the case of growing a 2-inch diameter ingot.

The laser cutting according to the present invention can be carried out with a relatively high precision by using numerical control. Therefore, if desired, an OF of the small-scale wafer can also be formed by the laser cutting as shown with a dotted line in Fig. 4.

### Third Embodiment

Fig. 5 is a schematic plan view showing a process of manufacturing single-crystal semiconductor wafers of a 2-inch diameter from a single-crystal semiconductor wafer of a 6-inch diameter in a third embodiment according to the present invention. This process of manufacturing in the third embodiment can also be carried out similarly as in the first embodiment described above.

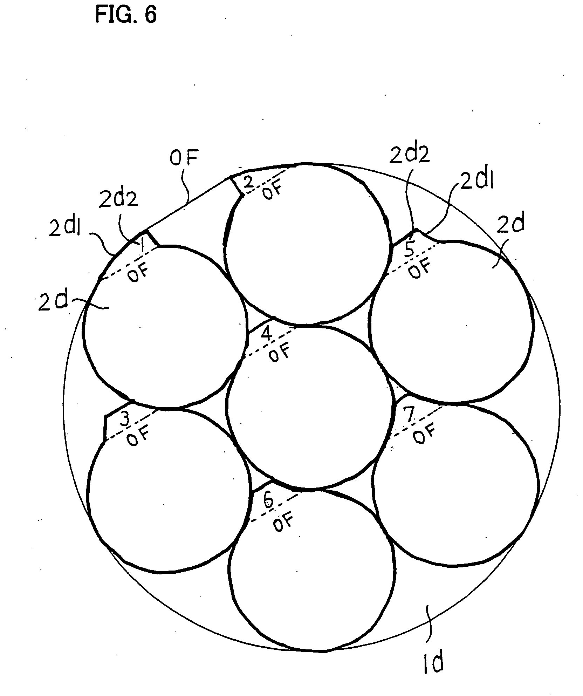

Namely, in the third embodiment, there is initially grown a single-crystal compound semiconductor ingot of a 6-inch diameter (actually, the diameter is slightly larger than 6 inches for including a grinding allowance), and then its outer periphery is ground and an OF is formed thereon. This 6-inch diameter ingot is cut by a slicer, a multi-saw or the like, to provide a 6-inch diameter wafer 1c. As shown in Fig. 5, 6-inch diameter wafer 1c can then be cut by a laser similarly as in the first embodiment to provide seven 2-inch diameter wafers 2c.

In other words, a single process of growing a 6-inch diameter ingot and a single process of slicing the ingot can provide seven times as many 2-inch diameter wafers as in the case of growing a 2-inch diameter ingot.

### Fourth Embodiment

Fig. 6 is a schematic plan view concerning a fourth embodiment similar to the third embodiment according to the present invention, showing a process of manufacturing single-crystal semiconductor wafers of a 2-inch diameter from a single-crystal semiconductor wafer having a 6-inch diameter. This process of manufacturing in the fourth embodiment can be carried out similarly as in the first embodiment described above.

Namely, in the fourth embodiment as well, there is initially grown a single-crystal compound semiconductor ingot of a 6-inch diameter (actually, the diameter is slightly larger than 6 inches for including a grinding allowance), and then its outer periphery is ground and an OF is formed thereon. This 6-inch diameter ingot is cut by a slicer, a multi-saw or the like, to provide a 6-inch diameter wafer 1d. As shown in Fig. 6, 6-inch diameter wafer 1 d can then be cut by a laser similarly as in the first embodiment to provide seven 2-inch diameter wafers 2d.

In other words, similarly as in the third embodiment, a single process of growing a 6-inch diameter ingot and a single process of slicing the same can provide seven times as many 2-inch diameter wafers as the case of growing a 2-inch diameter ingot.

In the fourth embodiment shown in Fig. 6, on the other hand, each of 2-inch diameter wafers 2d is cut out to have a protruding margin 2d1 to be gripped when cleavage is carried out so as to form an OF. Many compound semiconductors have significant cleavage characteristic along a crystal plane having a specific low index. Therefore, such cleavage characteristic can be utilized to form a presice OF conveniently and easily. In doing so, there has conventionally been made a wafer having a diameter larger than a target diameter in order to provide a margin to be gripped when cleavage is carried out. According to the fourth embodiment, however, there can be obtained a significant advantage that a wafer having a diameter larger than the target diameter need not be prepared even if cleavage is carried out to form an OF.

Furthermore, in the fourth embodiment, protruding margin 2d1 can be provided with an identification mark 2d2, which can be used to identify each other a plurality of small-scale wafers 2d cut out from single large-scale wafer 1d. For example, therefore, it is possible to determine that each of small-scale wafers 2d has been cut out from what part of large-scale wafer 1d. For identification mark 2d2, a number may be written in protruding margin 2d1 by using a laser beam used in laser cutting. Alternatively, a different number of dots or any other distinguishable marks may be provided thereto.

Generally, it is more difficult to grow a large-scale single-crystal ingot than to grow a small-scale single-crystal ingot, because various defects including twin crystals, polycrystals, crystal slips and others are more likely to be caused in growing a large-scale ingot than a small-scale one. Conventionally, a large-scale wafer cut out from an ingot's part having such a defect cannot be shipped as a product and goes to waste. Furthermore, when a chip or a crack occurs in slicing off a large-scale single-crystal wafer by a slicer or a multi-saw, the entire wafer cannot be shipped as a product and goes to waste. However, with a method of manufacturing small-scale single-crystal semiconductor wafers according to the present invention described above, there can be obtained a significant advantage that a large-scale wafer including a defect(s) can be cut into small-scale wafers, among which those having been cut out from non-defective ports can be shipped as products.

In the aforementioned embodiments, although a laser cutting method is described as a method of cutting out small-scale wafers from a large-scale wafer, it is also possible to use a well-known electric discharge machining method. In doing so, there can be used a thin-walled cylindrical discharging electrode having a peripheral shape corresponding to the shape of a small-scale wafer to be cut out. In addition to these cutting methods, it is further possible to use a well-known wire saw method, an ultrasonic method, and a grinding method by means of a cylindrical core on which diamond is electrically Furthermore, of course, a plurality of large-scale wafers may be stacked for cutting simultaneously into small-scale wafers as long as the stack can be cut.

Although a large-scale compound semiconductor wafer to be cut has a 6-inch diameter at most at present, it goes without saying that the present invention can be applied to a larger wafer having an 8-inch or 12-inch diameter which will be manufactured in the future. Similarly, although small-scale wafers cut out have a 2-inch diameter in the aforementioned embodiments, it goes without saying that the present invention can be used even in the case that a large-scale wafer to be manufactured in the future is cut into small-scale wafers having a diameter of 3 inches ore more (for example, a 9-inch diameter wafer can be cut to provide seven 3-inch wafers). Moreover, in the present invention, small-scale wafers cut out from a large-scale wafer are not required to have the same diameter. For example, it is also possible to cut a single large-scale wafer to provide a small-scale wafer(s) of a 2-inch diameter and one(s) of a 3-inch diameter simultaneously.

Furthermore, the present invention is not limited to the wafer of the compound semiconductor such as GaAs or InP described above, and can naturally be applied to any other compound semiconductor wafer such as GaN.

### Industrial Applicability

As described above, according to the present invention, there can be provided a method of efficiently manufacturing single-crystal semiconductor wafers of a relatively small diameter from a single-crystal semiconductor ingot of a relatively large diameter at low costs, and a laser machining apparatus which can be used therefor. In particular, it is possible to provide still-highly-demanded compound semiconductor wafers of a relatively small diameter with high productivity and at low costs.

## Claims

1. A method of manufacturing single-crystal semiconductor wafers, wherein a plurality of single-crystal semiconductor wafers of a relatively small diameter (2a-d) desired by users are cut out from a single-crystal semiconductor wafer of a relatively large diameter (1a-1d).

2. The method of manufacturing single-crystal semiconductor wafers according to claim 1, wherein said semiconductor is a compound semiconductor.

3. The method of manufacturing single-crystal semiconductor wafers according to claim 2, wherein said compound semiconductor is selected from the group consisting of GaAs, InP, and GaN.

4. The method of manufacturing single-crystal semiconductor wafers according to claim 1, wherein said large-scale wafer has a thickness in a range of 0.15 mm to 1.5 mm

5. The method of manufacturing single-crystal semiconductor wafers according to claim 1, wherein said small-scale wafers are cut out by a method selected from the group consisting of a laser method, an electric discharge machining method, a wire saw method, an ultrasonic method, and a grinding method by means of a cylindrical core on which diamond is electrically deposited.

6. The method of manufacturing single-crystal semiconductor wafers according to claim 1, wherein at least three said small-scale wafers having a diameter of 2 inches or more are cut out from said large-scale wafer having a diameter of 4 inches or more.

7. The method of manufacturing single-crystal semiconductor wafers according to claim 6, wherein at least four said small-scale wafers having a diameter of 2 inches or more are cut out from said large-scale wafer having a diameter of 5 inches or more.

8. The method of manufacturing single-crystal semiconductor wafers according to claim 7, wherein at least seven said small-scale wafers having a diameter of 2 inches or more are cut out from said large-scale wafer having a diameter of 6 inches or more.

9. The method of manufacturing single-crystal semiconductor wafers according to claim 1, wherein a total main surface area of said small-scale wafers cut out from said large-scale wafer corresponds to at least 50% of a main surface area of said large-scale wafer.

10. The method of manufacturing single-crystal semiconductor wafers according to claim 1, wherein defective parts included in said large-scale wafer correspond to at most 65% of a main surface area of said large-scale wafer.

11. The method of manufacturing single-crystal semiconductor wafers according to claim 1, wherein said small-scale wafers are cut out from a plurality of said large-scale wafers in a stacked state.

12. The method of manufacturing single-crystal semiconductor wafers according to claim 1, wherein each of said small-scale wafers has a mark for indicating a part of said large-scale wafer from which each of said small-scale wafers is cut out.

13. The method of manufacturing single-crystal semiconductor wafers according to claim 1, wherein each of said small-scale wafers has an orientation flat and an index flat.

14. The method of manufacturing single-crystal semiconductor wafers according to claim 1, wherein each of said small-scale single-crystal semiconductor wafers is cut out to have a protruding margin to be gripped when cleavage is carried out so as to form an orientation flat.

15. The method of manufacturing single-crystal semiconductor wafers according to claim 14, wherein each of said small-scale wafers has, in said protruding margin, a mark for indicating a part of said large-scale wafer from which each of said small-scale wafers is cut out.

16. The method of manufacturing single-crystal semiconductor wafers according to claim 1, wherein each of said small-scale wafers has a notch for easy determination of its crystal orientation and alignment.

17. The method of manufacturing single-crystal semiconductor wafers according to claim 1, wherein said small-scale wafers are cut out by using a YAG laser beam.

18. The method of manufacturing single-crystal semiconductor wafers according to claim 17, wherein said YAG laser is a pulse laser.

19. The method of manufacturing single-crystal semiconductor wafers according to claim 18, wherein said small-scale wafers are cut out such that a plurality of holes in said large-scale wafer each made by a single shot of said pulse laser are aligned successively with the neighboring holes overlapping each other in a range of 30% to 87% of their diameters.

20. The method of manufacturing single-crystal semiconductor wafers according to claim 17, wherein said large-scale wafer has a main surface as sliced from an ingot, a main surface subsequently washed, or a main surface after a surface layer is etched away by a thickness of at most 10 µm, and said main surface is irradiated with said laser beam.

21. The method of manufacturing single-crystal semiconductor wafers according to claim 17, wherein said large-scale wafer before cutting is supported by a plurality of supporting means for supporting the plurality of said small-scale wafers to be obtained after cutting.

22. The method of manufacturing single-crystal semiconductor wafers according to claim 21, wherein each of said supporting means has a supporting area smaller than each of said small-scale wafers.

23. The method of manufacturing single-crystal semiconductor wafers according to claim 22, wherein each of said supporting means is a vacuum chuck.

24. The method of manufacturing single-crystal semiconductor wafers according to claim 22, wherein each of said supporting means is a pinholder, and a weight is placed on the wafer and arranged above said pinholder or a magnet is placed on the wafer and arranged above said pinholder having a magnetic property, so as to support said wafer more stably.

25. The method of manufacturing single-crystal semiconductor wafers according to claim 17, wherein a gas jet is given to blow off residues caused during cutting with said laser beam.

26. The method of manufacturing single-crystal semiconductor wafers according to claim 25, wherein said gas and said residues are sucked and introduced into a dust collector.

27. The method of manufacturing single-crystal semiconductor wafers according to claim 25, wherein said laser beam is adjusted such that an opening made by cutting with said laser beam has a width larger on a main surface side of said wafer to which the laser beam is incident than on the other main surface side, and a side surface of the opening is made at an angle ranging from 65 to 85 degrees with respect to the main surface of said wafer.

28. The method of manufacturing single-crystal semiconductor wafers according to claim 17, wherein each of said small-scale wafers has a mark for indicating that each of them is cut out from what part of each of plurality of said large-scale wafers sliced from the same ingot, and said small-scale wafers cut out from the corresponding parts of said large-scale wafers are grouped into the same lot.

29. The method of manufacturing single-crystal semiconductor wafers according to claim 17, wherein residues caused during cutting and adhered to a periphery of each of said small-scale wafers are removed by rubbing.

30. The method of manufacturing single-crystal semiconductor wafers according to claim 29, wherein a peripheral side layer of each of said small-scale wafers is removed by a grinding allowance of at most 0.3 mm with a grinder of rubber.

31. The method of manufacturing single-crystal semiconductor wafers according to claim 30, wherein said peripheral side layer is removed by a grinding allowance of at most 0.1 mm, and either edge or both edges of the peripheral side are beveled by a grinder of rubber.

32. The method of manufacturing single-crystal semiconductor wafers according to claim 30, wherein the entire surface of each of said small-scale wafers is etched to remove contaminations after the wafer's periphery is processed by the grinder of rubber.

33. A laser machining apparatus for cutting out a plurality of single-crystal semiconductor wafers of a relatively small diameter from a single-crystal semiconductor wafer of a relatively large diameter by a laser beam, comprising:
a plurality of supporting means (12) for supporting from underneath a plurality of regions to be cut out from said large-scale wafer to provide the plurality of said small-scale wafers;
a laser device including a laser beam window (13) supported by an XY stage above the wafer; and
a gas ejector (16) for giving a gas jet to blow off residues caused during cutting with the laser beam.

34. The laser machining apparatus according to claim 33, wherein each of said supporting means includes a vacuum chuck or a pinholder, and has a supporting area smaller than a main surface of each of said small-scale wafers.

35. The laser machining apparatus according to claim 34, wherein each of said supporting means includes a pinholder having a magnetic property, and further includes a magnet to be placed on said wafer and arranged above the pinholder.

36. The laser machining apparatus according to claim 33, wherein said gas ejector as well as said laser device is supported by said XY stage.

37. The laser machining apparatus according to claim 33, further comprising a dust collector for sucking the gas and the residues below said wafer to remove the residues.

38. The laser machining apparatus according to claim 33, wherein said laser device is a YAG laser device.

39. The laser machining apparatus according to claim 38, wherein said YAG laser device is a pulse laser device.

40. The laser machining apparatus according to claim 33, wherein said laser beam window (13) is connected to a laser generating source (15) via an optical fiber (14).
